Europäisches Patentamt

European Patent Office

Office européen des brevets

(11) Publication number: **0 177 686 B1**

# EUROPEAN PATENT SPECIFICATION

(45) Date of publication of patent specification: **17.04.91**  (51) Int. Cl.5: **H05K 3/42**, H05K 3/44, H05K 3/38

(21) Application number: **85108864.1**

(22) Date of filing: **16.07.85**

(54) **Process for bonding metals to electrophoretically deposited coatings, and printed circuit with plated through holes produced thereby.**

(30) Priority: **18.07.84 US 632041**

(43) Date of publication of application:
**16.04.86 Bulletin 86/16**

(45) Publication of the grant of the patent:
**17.04.91 Bulletin 91/16**

(84) Designated Contracting States:
**CH FR IT LI NL SE**

(56) References cited:
**DE-A- 2 811 150**
**DE-A- 2 933 251**
**FR-A- 2 099 902**
**JP-A-51 049 468**
**JP-A-53 111 470**

(73) Proprietor: **KOLLMORGEN CORPORATION**
**10 Mill Pond Lane**
**Simsbury, CT 06070(US)**

(72) Inventor: **Arachtingi, James J.**
**1146 Park Boulevard**
**Massapequa Pk., NY 11762(US)**

(74) Representative: **Königseder-Egerer, Claudia D.**
**Zugspitzstrasse 65**
**W-8104 Grainau(DE)**

EP 0 177 686 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid (Art. 99(1) European patent convention).

EP 0 177 686 B1

## Description

This invention relates to an improved process for depositing an adherent metal layer to a metal core substrate provided with insulating top layers having an electrophoretically deposited coating on its hole walls and the article produced thereby. More particularly, this invention relates to metal core printed circuit boards and a process for producing same.

Metal core substrates used for printed circuits have an insulating layer to insulate individual printed circuit conductors from the metal core. Among the advantages of such metal core substrates are temperature equalization, ground plane shielding, dimensional stability, elimination of warp and high structural strength.

Metal core boards have been used in the past. Oversized holes are drilled in a metal core such as aluminum, copper-clad epoxy prepreg is laminated on each side, taking care to fill the holes completely with epoxy provided by the prepreg in the course of laminating; the holes are drilled to size; and then the circuit is fabricated by conventional processing including plating through connections by means of hole wall metallization.

For example, to produce a plated through hole with a finished diameter of 1 mm, a 1,15 mm diameter hole must be drilled in the epoxy plug to allow for copper plating to a minimum thickness of, e.g., 0,05 mm on the hole walls. Also, an epoxy ring having a minimum thickness of 0,25 mm must remain in the hole to prevent the entire epoxy plug from being torn out of the hole during the second drilling operation. In addition, allowance must be made for cumulative registration errors in the first and second drilling operations by adding another 0,08 to 0,13 mm thickness to the diameter of the original hole to be drilled in the metal substrate. Thus, to produce a finished hole diameter of 1 mm, the original hole in the metal substrate must be drilled to a diameter of 1,73 mm to 1,78 mm. When holes are drilled on 2,54 mm centers, the double drilling operation leaves a web having a width of 0,76 mm to 0,81 mm. The hole-to-hole distance cannot be made smaller than 2,54 mm, because the first hole must be so much larger than the finished hole. This makes it difficult to increase the component packaging density.

The epoxy plugs sometimes are formed by laminating a sheet of copper foil with one or more sheets of glass cloth impregnated with epoxy resin (epoxy prepregs) to one side of the metal substrate. The epoxy resin flows through the holes in the substrate forming the hole plugs. Then a sheet of copper foil and epoxy prepregs are laminated to the second side of the metal substrate. Lamination employed in this method is a two stage process. If lamination of both sides of the metal substrate occurred simultaneously instead of successively, air would easily be trapped in holes in the metal substrates when both ends of the holes were covered with impervious layers. With the two stage lamination process, it is easier for air bubbles to escape and for a uniform plug of epoxy to fill the holes.

This two stage lamination process has, however, disadvantages. Manufacturing yields are poor. Also, the costs associated with the use of high flow resin prepregs, double laminating and double drilling and the problems associated with maintaining tolerances during the double drilling steps are about seven times higher than compared to the costs of a conventional printed circuit board. Therefore, this type of metal core printed circuit board has not found wide acceptance, but has been used for temperature equalization in avionics, where conventional cooling systems are too bulky and ineffective.

Metal core printed circuit boards also have been manufactured in large quantities using steel substrates having a thickness of 0,5 to 1,0 mm. Holes for through connections are punched in the steel substrates. Then, the steel substrates are coated by a fluidized bed powder coating process which deposits an insulating layer of epoxy resin in powder form on the substrates and on the hole walls. However, when the epoxy resin powder on the steel substrate is fused, as is required to cure the coating, the epoxy flows slightly, This creates a thin coating at the top and bottom rims of the holes, and a thick ring of epoxy resin in the center of the holes. To produce an adequate coating thickness at the top and bottom rims of the holes, it is necessary to deposit resin to a thickness of 0,35 mm or more on the surface and in the center of the holes. Thus, 2mm holes must be formed on 2,54 mm pitch in order to achieve the standard 1 mm hole required for Dual-in-Line-Packages. Because only 0,5 mm of the steel substrate remains between the holes, the surface between the holes is rounded, not flat, and it is difficult to print on such surface. This limits the usefulness of the powder coating technique with respect to high density circuit patterns.

Electrophoretically deposited polymers have been widely used as the primer coating on automobile bodies and a variety of appliances. Japanese Patent Publication 39076 of 1981 suggests that metal substrates for printed circuits can be insulated with electrophoretically deposited coatings. The coatings flow, however, when they are cured, and, as in the case of epoxy powder fluidized bed coatings, this produces a thin coating at the top and bottom rims of the holes and an excessively thick coating in the center. The process, therefore, has not been successful in making a commercially useful product.

2

Japanese Patent Publications 51-49468/1976, 53-111470/1978 and 55-24716/1980 and US 4,321,290 disclose that a truly cylindrical surface in the holes can be achieved by first providing the surface of a metal substrate with an insulating layer of uniform thickness before producing holes for through connections; after the holes are made, the metal walls of the holes are etched back creating an overhang or lip of the insulating layer at the top and bottom of the hole walls. Then, a resin is electrophoretically deposited on the metal walls of the holes creating a uniform film of resin on the hole walls without producing thinning of the coating at the top and bottom rims of the holes, and without producing a thick ring at the center.

Another process for producing metal clad boards is suggested in DE-OS 2811150. In this process, the metal core forming the hole walls is etched to increase the hole diamater to accomodate an electrophoretically deposited resin layer.

The process for producing metal core printed circuit boards claimed in FR-A 2099902 includes coating a metal sheet with several, up to ten resin layers. The core metal is preferably aluminium. Through holes are provided and used for interconnecting the circuitries on both sides of the metal core sheet. The coating is done by applying a fluid resin that also covers the hole walls and serves as the hole wall insulation.

In practice, it has been found that the known resin systems for coating the hole walls are not a suitable base for the metallized through hole walls required in the printed circuit art. Despite large investments of manpower and research efforts by major manufacturers of electronic equipment for the computer and telecommunications industries, attempts to practice these inventions, therefore, were unsuccessful. It was found that copper deposits would not adhere to the hole walls and, further, that the electrical insulating properties are inadequate. For these reasons, the teachings of the prior art have not found commercial application.

It is an object of this invention to provide an improved process for making printed circuits on a metal substrate provided with plated through hole wall connections.

It is a further object of this invention to provide a process for forming adherent metal deposits on electrophoretically coated hole walls.

Another object of this invention is to provide electrophoretically deposited hole wall coatings of substantially uniform thickness which possess good insulating properties and are capable of being adhesion promoted.

Other objects and advantages of the invention will be set forth in part herein and in part will be obvious herefrom or may be learned by practice of the invention.

The process of the invention for producing a printed circuit network on a metal core substrate comprises the successive steps of providing the surfaces of a metal core with one or more insulating surface layers to form the metal core substrate; providing said substrate with one or more holes for through connections; etching the hole walls defined by the metal core and by the insulating layer(s) to enlarge the hole diameter by a predetermined amount only in the portion of the hole(s) extending through said metal core; electrophoretically depositing on the etched portions of said hole walls a resinous coating from a resin solution, which solution comprises a solid filler being selected from metal silicates, such as aluminium or zirconium silicate, said filler being present in a concentration from 3 to 10% by weight of the cured resinous coating, and said filler further having an average particle size not exceeding 1 $\mu$m in diameter, and being non-reactive with and uniformly dispersed in the resin solution, whereby the said concentration of the filler is selected such that the deposited resinous coating has a volume resistivity above $10^4$ Megohm-cm; curing the resinous coating, whereby the thickness of the resulting coating exceeds 0,025 mm; adhesion promoting the surface of the cured resinous coating containing said filler, thus creating a hydrophilic, micro-etched surface; depositing a metal layer on the resinous coating of the hole wall(s) and on the insulating surface layers, or selected parts thereof; and forming said printed circuit network.

The invention also relates to a printed circuit board comprising a metal core, insulating layers superimposed on the surfaces of said metal core and at least one hole through the insulating layers and metal core, the hole diameter defined by the metal core being greater than the hole diameter defined by the insulating layers; the metal walls of said hole(s) being coated with a resinous coating, said coating comprises a solid filler being selected from metal silicates, such as aluminium or zirconium silicate, said filler being present in a concentration from 3 to 10% by weight of the cured resinous coating, and said filler further having an average particle size not exceeding 1 $\mu$m in diameter, and being non-reactive with and uniformly dispersed in the resin solution, whereby the said concentration of the filler is selected such that the deposited resinous coating has a volume resistivity of $10^4$ Megohm-cm; said deposited resinous coating then being cured, whereby the thickness of the resulting coating exceeds 0,025 mm, said printed circuit board being produced in accordance with the process described above.

Applicant has found that adhesion of a metal layer on an electrophoretically deposited resin coating is improved by incorporating solid fillers in finely divided form in the electrophoretically deposited coating, curing and then adhesion promoting a surface of the coating to expose filler particles at the surface of the coating and depositing a metal layer on the surface of the coating.

In the process for carrying out this invention, a sheet of metal, also referred to as metal panel, is provided on both surfaces with an insulating coating or layer thus forming a metal core substrate. Copper foil optionally may be provided on the insulating coating. Holes are made through copper cladding, if present, the insulating coatings and the metal panel of the substrate at preselected points where through connections will be needed for the printed circuit. The exposed metal core on the walls of the holes is etched back to provide an overhang of insulation at the top and bottom walls of the holes formed by said insulating layers. The metal core substrate is then immersed in a resion dispersion and the insulating resin layer is electrophoretically deposited on the walls of the holes.

The resin dispersion contains a solid filler in finely divided form and in an amount from 1 to 25% by weight, and preferably 3 to 10% by weight of the cured resinous coating and sufficient to subsequently provide adhesion for the metallic layer, but insufficient to adversely affect the mechanical or insulating qualities of the final insulation layer. The filler must be compatible with the dispersed resin system. Thus, in acidic cationic systems, no car bonates can be used, i.e., calcium carbonate is a suitable filler for anodic, but not for cathodic coatings. Salts and other impurities should be kept to a minimum in all parts of the system. The filler codeposits with the resin on the hole walls.

The insulating layer on the hole walls is fused and cured by heat. After the insulating layer is cured, its surface is adhesion promoted. A printed circuit conductor network is imposed on the insulating coating covering the outer surfaces of the metal sheet and on the adhesion promoted hole wall coating. The printed circuit network is, where desired, connected from one side of the metal substrate to the other by means of said metal deposits on the insulating layer in the holes. The printed circuit conductors on the outer surfaces may be established before, simultaneously with, or after the hole walls are metallized, depending on the printed circuit manufacturing method selected. The metal of the substrate is usually in sheet form, and can be of various thicknesses depending upon the application. Where some flexibility is required in the final printed circuit package, the metal substrate can be as thin as 0,1 mm; and where heavy components such as transformers are to be supported on the circuit package, it can be as thick as 3 mm or more. However, in most applications, the preferred thickness is from 0,5 to 1,3 mm. The choice of metal also depends on the application. Steel often is preferred for economy. For many applications where weight is an important factor, aluminum is used. Aluminum also is a better heat conductor than steel, and is easier to fabricate. Some printed circuits require a substrate with the same coeficient of thermal expansion as ceramic circuit packages. For these applications, special alloys, such as copper clad Invar®, an iron-nickel alloy containing 36% nickel nickel, and Alloy 42®, an iron-nickel alloy containing 42% nickel, are preferred.

The resins used for the electrophoretically deposited resinous coating must have good insulating properties, and sufficient thermal stability to withstand the soldering temperatures to which printed circuits are subjected. Typically, printed circuits are tested at solder temperatures of 288° C, but in some manually soldered printed circuits, soldering temperatures may reach 425° C for a short time at the contact point of the soldering iron. In addition to having good insulating and thermal properties, the resin system must be able to achieve a polar surface suitable for metallization, i.e., it should be adhesion promotable. Suitable resins for this invention include thermosetting resins selected from acrylics, alkyds, epoxies, epoxy-acrylates, polyesters, polyamide-imides, polyimides and mixtures thereof. It is believed that suitable resins for this invention also include thermoplastic resins such as acrylates, polysulfones, polyetherether ketones, or other engineering grade thermoplastics, and mixtures of the foregoing resins.

Included among the electrophoretically deposited coatings suitable for insulating walls of holes in metal substrates according to this invention are the autophoretically deposited or autodeposition coatings. In the autophoretic process, the coating is deposited by chemical precipitation from a resin emulsion containing a synthetic polymer. In one system, the resin emulsion contains a synthetic polymer, hydrogen fluoride and an oxidant, e.g., hydrogen peroxide. The hydrogen fluoride and the oxidant oxidize the iron of the metallic substrate to ferric ions. The ferric ions react with the resin emulsion causing destabilization and deposition of the resin as a film on the steel substrate. After deposition, the film is cured.

Adhesion promotion of cured resin surfaces is usually a chemical or combined chemical and electrical treatment. Adhesion promotion systems, per se, are well known in the printed circuit and plating-on-plastics arts. Among the adhesion promotion systems are aqueous oxidizing solutions such as permanganate solutions, chromic acid solutions, blends of chromic and sulfuric acids, or of chromic acid, sulfuric acid and phosphoric acid and the like. Adhesion promotion can also be achieved by corona discharge, or by the plasma technique wherein the composition of the gas comprising the plasma is selected according to the surface to be adhesion promoted.

It has been found that prior art electrophoretically deposited coatings cannot be adequately adhesion promoted. The cured electrophoretically deposited coatings do not provide adequate adhesion if exposed to the milder adhesion promotion techniques, and such coatings are so thin that the more severe adhesion promotion destroys the bond of the coating to the metal substrate, or the coating itself. It was found that electrophoretically deposited coatings less than 12 $\mu$m thick are usually too thin to be adhesion promoted successfully,

If there are asperities or small projections of metal left when the walls of the holes are etched back before the electrophoretically deposited coating is applied, coatings with thicknesses, before adhesion promotion, in the range of 18 to 30 $\mu$m often are not thick enough. The electrophoretically deposited coating flows when cured and leaves a thinner coating over the asperities. When such a thin coating is adhesion promoted, the asperity is exposed. Copper or other metal deposited on the hole wall then will create a short circuit through the asperity to the metal substrate.

More reliable insulation is obtained when the coating thickness before adhesion promotion is in excess of 25 $\mu$m, preferably 30 $\mu$m, and most preferably 35 $\mu$m or greater. Prior art coatings were not suitable for providing a base for metallization, causing voids in the metal layer due to poor adhesion of the catalyst employed for rendering the surface receptive to electroless metallization, or of the initial metal deposit, or metal layer, which poorly adhered and blistered or flaked off.

Surprisingly, it has been found that the addition of certain solid, particulate fillers to the electrophoretically de posited resin system makes possible adhesion of metallization layers to the hole walls, i.e., the electrophoretically deposited, cured and adhesion promoted wall coatings.

It has been found that although adhesion promotion or unfilled coatings may provide a hydrophilic surface, adequate adhesion cannot be obtained. It is believed that adhesion promotion of filled coatings exposes filler particles and provides a microporous, hydrophilic surface and thus causes a substantially improved bond to the metal layer deposited on it.

Suitable fillers for applicant's invention are (1) suspendable in the electrophoretic dispersion solution; (2) capable of being co-deposited with the electrophoretic resin; (3) compatible with subsequent processing; and (4) a good reinforcement for the resin system. At the same time, the fillers must also have good insulating properties, or only be present in such quantities as to avoid detrimentally affecting the insulating capabilities of the dielectric layer formed by the filled resin.

In accordance with this invention, the concentration of filler in the resinous coating is selected so that the volume resistivity of the resulting coating equals, and preferably exceeds the value necessary to adequately insulate the metal core from the metal layer deposited on the hole wall coating, i.e., above $10^4$ megohm-cm, and preferably above $10^5$ megohm-cm.

Suitable fillers according to this invention include clays, silica and silicates such as talcs and aluminum silicates.

The fillers are added in particulate form having an average particle size of 5 $\mu$m or less with less than 0,5% of the filler particles being retained on a 44 $\mu$m mesh screen (ASTM 325). More preferred fillers have an average particle size of 1 micron or less, and less than 0,1% of the filler particles are retained on a mesh screen (ASTM 325).

The adhesion achieved between the hole wall coating and the metal deposit formed on its cured and adhesion promoted surface does pass the so-called "tape test", i.e., resist separation when tested at at least 0,1 N/mm with pressure sensitive tape. Such adequate adhesion of the metal film to the electrophoretically deposited coating ensures that there are no blisters formed between the metal and the coating on the hole walls.

Electrophoretically deposited coatings of the invention exhibit, after curing, a dielectric breakdown voltage of at least 1000 V, and preferably of at least 2500 V. More preferred are cured coatings with a dielectric breakdown voltage of over 5000 V.

To increase the thickness of the electrophoretically deposited coatings, the temperature of the coating solution may be increased, more solvent may be added to the resin composition, a higher deposition voltage may be used, or the voltage may be increased with time and thus thickness, or a combination of these techniques may be used. Applicants have found that the thickness of the electrophoretically deposited coating, after curing, should at least be 0,025 mm, and preferably from 0,035 to 0,12 mm. Most preferred is a thickness of less than 0,055 mm after curing and before adhesion promotion. When the filled resinous coating layer is too thick, it tends to flow during the cure thus causing non-uniformity of the resulting hole wall coating.

Depending on the composition, the electrophoretic resin system may be either deposited on the anode or the cathode, i.e., the metal substrate to be coated may be used as either the anode or the cathode. With anaphoretic coatings there is a slight possibility that the metal ions may be anodically dissolved from the substrate and incorporated in the coating, thereby reducing the electrical insulating properties. For this

5

reason, cathaphoretic coatings are preferred.

The printed circuit pattern may be applied to the exterior insulated surface of the substrate by any conventional printed circuit technique, i.e., subtractive, semi-additive, additive processes or discrete wiring techniques. A process sequence employing a conventional technique for manufacturing printed circuit conductor patterns comprises the steps listed below:

1. After the hole walls have been coated and the cured coating layer adhesion promoted, the copper clad metal core substrate is cleaned and immersed in a commercial cleaner/ conditioner solution etc., and treated to render the hole walls receptive to metal deposition

2. After rinsing, copper is electrolessly deposited on the copper foil surface and on the hole walls. Then, a printed circuit plating resist image is formed, usually by imprinting a negative electroplating resist pattern on the surface and copper and tin-lead is electroplated on all areas not covered with the plating resist including the hole walls. After removing the plating resist, the exposed copper layers between the tin-lead plated conductors are removed by etching.

This invention is more fully described hereinafter with reference to the accompanying drawings illustrating certain embodiments of the invention and, together with the specification, serve to explain the principles of the invention. Figures 1A to 1E illustrate a procedure suitable for the manufacture of printed circuit boards from insulated metal substrates.

Fig. 1A is a side view in cross-section of a metal core substrate with an epoxy impregnated glass cloth insulation inner layer and a copper foil outer layer on each side of metal core.

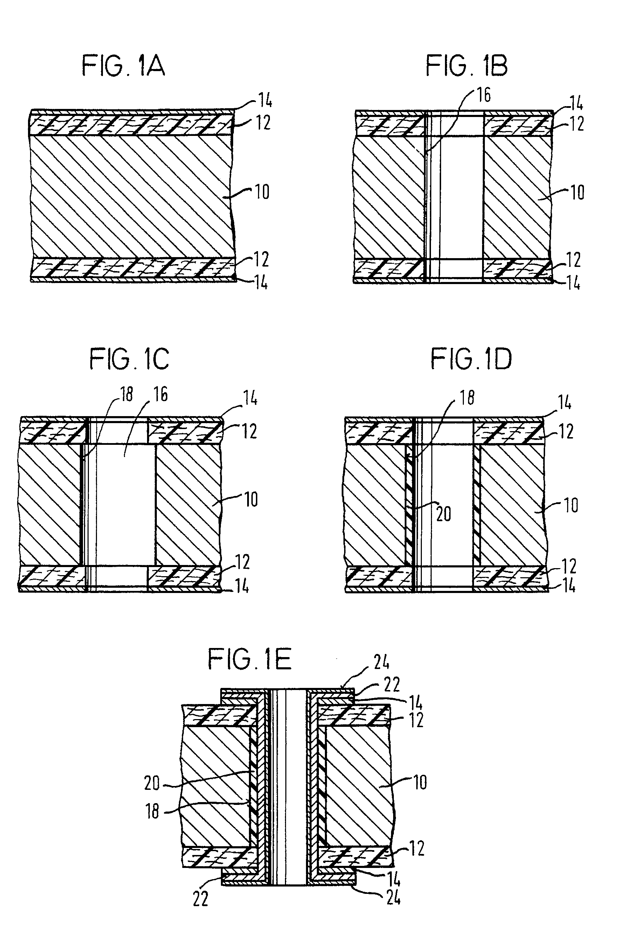

Fig. 1B is a side view in cross-section of the metal core substrate and its covering layers with a hole drilled therethrough.

Fig. 1C is a side view in cross-section of the metal core substrate in which the walls of the hole formed by the metal core have been etched to enlarge the diameter.

Fig. 1D is a side View in cross-section of the substrate in which a coating has been electrophoretically deposited on the hole walls formed by the metal core.

Fig. 1E is a side view in cross-section of the metal core substrate with a completed plated through hole wall connection.

A process for carrying out the invention using the subtractive technique of manufacturing printed circuit boards is illustrated in the drawings. In Fig. 1A, a metal core sheet 10 is laminated with epoxy prepregs 12 and copper foil cladding 14 on both sides.

In Fig. 1B, hole 16 for a through connection is drilled through the copper surface foils 14, the epoxy glass cloth insulation 12 and the metal core 10. As shown in Fig. 1C, the wall 18 of the metal core 10 defining the hole 16 is etched back 50-100 μm.

The etchant used to etch the metal core should not substantially attack the surface copper foils 14; thus, an aluminum metal core with copper foils as its surface may be etched by exposure to a sodium hydroxide solution. If it is necessary to use an etchant that will attack the surface copper foils, the foils should be protected with a resist during the etching process. Alternately, the metal core my be etched electrolytically by making the metal core an anode in a suitable electrolyte.

After the metal core 10 has been etched back in the hole 16, the panel is immersed in a resinous coating solution of the invention, and a voltage (typically 100 - 300 V) is applied to electrophoretically deposit the coating. Voltage is applied only to the metal core 10 and not to the surface copper foils 14, so that the resinous coating is electrophoretically deposited only on the walls of the hole 16 in the metal core 10 and not on the surface copper foils 14. After electrophoretic deposition, the panel is rinsed, dried and then heat-cured.

Fig. 1D shows the electrophoretically deposited coating 20, after it has been cured or fused, filling the etched back portion of the hole wall 18 in the metal core 10. The coating 20 is adhesion promoted to microetch its surface and render it hydrophilic. Subsequently, copper is electrolessly deposited by conventional techniques. The copper film on the hole walls and on the surface of the copper foils 14 is reinforced with an additional metal deposit. A negative of the plating resist masking layer corresponding to the printed circuit conductor pattern is printed on the copper surface, and the exposed areas as well as metal layer on hole walls are provided with an electroplated metal deposit thus forming the circuit conductor pattern. Fig. 1E illustrates the finished plated through hole, wherein the electrophoretically deposited coating 20 is overlaid with a layer of electrodeposited copper 22 and a tin-lead electrodeposit 24. The tin-lead electrodeposit 24 has been used as an etch resist protecting the printed circuit conductors during removal of the unwanted portions of the copper foils 14 exposed after removing the plating resist masking layer.

A semi-additive process follows the same procedure except that instead of surface copper foils the insulating top layers attached to the metal core are provided with surfaces which can be adhesion promoted and made receptive to metal deposition. Thus, simultaneously with the hole wall metallization, the insulating surfaces of the metal core substrate also receive a film of electrolessly deposited metal.

Similarly, a fully-additive process may be used.

## EXAMPLE 1

Resinous coatings with and without filler were electrophoretically deposited on the surface of aluminum panels in order to test the adhesion of electrolessly formed metal deposits on these coatings.

The aluminum surface was prepared by solvent degreasing, a mild alkaline etching step, rinsing and acid dipping in an acidic solution.

Electrophoretic Solution Make-up:

|  | Unfilled | | Filled | |
|---|---|---|---|---|
| resin K5276A® * | 560,0 | g | 132 | g |
| resin K5268® ** | 55,8 | g | 13 | g |
| lactic acid | 19,8 | ml | 4,9 | ml |
| phosphoric acid | 7,3 | ml | 1,7 | ml |
| defoamer (tetramethyl decynediol) | -- | | 0,1 | g |
| filler *** | -- | | 5,9 | g |
| deionized water | 3357,1 | ml | 842,4 | ml |

\* A cathodic epoxy-amino resin in 23% ethylene glycol monobutyl ether and 6% ethylene glycol monohexyl ether

\*\* A cathodic epoxy resin with hardener in 38% ethylene glycol monobutyl ether

\*\*\* A hydrous aluminum silicate clay with an average particle size of 0,5 μm

The unfilled resinous coating according to the prior art was used as a control. The filled resinous coating had a filler-to-resin ratio of 1 to 16.

The resinous coatings were produced by cataphoresis from agitated solutions in stainless steel tanks with the tanks acting as the anode. The coatings were applied at 125 V for 2 minutes at a solution temperature of 24,5° C. After rinsing and air drying, the formed coatings were cured at 175° C for 40 minutes.

The resin coated aluminum panels were immersed for 3 minutes at 45° C in the following acidic pre-treatment solution:

| | | |
|---|---|---|
| chromium trioxide | 20 | g |
| sulfuric acid | 600 | ml |
| phosphoric acid | 100 | ml |
| deionized water | 300 | ml |
| wetting agent | 2 | g |

7

rinsed, and immersed in the following oxidizing adhesion promoting solution:

```
chromium trioxide           900  g/l
time                          8   minutes
temperature                 room
```

After neutralization in sodium metabisulfite solution and rinsing, the panels were ready for electroless metallization.

The panels were immersed in a commercially available aqueous cleaner-conditioner solution for 5 minutes at 60°C; rinsed in cold water for 5 minutes; immersed for 3 minutes at ambient temperature in an acidic solution of tin chloride dissolved in a sodium chloride brine; immersed for 5 minutes at 30°C in a commercially available palladium-tin-chloride catalyst solution; rinsed in cold water for 5 minutes; immersed for 4 minutes at ambient temperature in dilute fluoroboric acid solution; rinsed in cold water for 5 minutes; and immersed for 20 minutes at 50°C in an electroless copper deposition solution comprising

```
copper sulfate pentahydrate           12   g/l
ethylenediamine tetra-2propanol       15,4 g/l
alkylphenoxypolyglycidyl-
  phosphate ester                     0,16 g/l
sodium cyanide                        10   mg/l
potassium sulfide                      1   mg/l
2-mercaptobenzothiazole               0,1  mg/l
formaldehyde (37%)                    3,5  ml/l
sodium hydroxide                      8,4  g/l
```

The panel provided with the filled resinous coating displayed a smooth, faultless, blister-free deposit of copper securely adhered to the surface of said coating layer.

On the unfilled resinous coating prepared according to the prior art, copper blistered off in the electroless plating solution.

EXAMPLE 2

Aluminum panels were prepared as in Example 1. The amount of filler in the electrophoretic coating solution used was varied as follows:

| Filler-to-Resin Ratio | 1 : 4 | 1 : 32 | 1 : 64 |
|---|---|---|---|
| resin K5276A ® | 41,6 g | 198 g | 136 g |
| resin K5268 ® | 7,7 g | 19,5 g | 13,4 g |
| phosphoric acid | 0,5 ml | 2,55 ml | 1,7 ml |
| lactic acid | 1,9 ml | 7,4 ml | 4,9 ml |
| defoamer (tetramethyl decynediol) | 0,1 g | 0,14 g | 0,02 g |
| filler (a hydrous aluminum silicate clay with an average particle size of 0,5 µm) | 8,0 g | 8,8 g | 1,47 g |
| deionized water | 340 ml | 762,5 ml | 843,5 ml |

Application of the resinous coating, adhesion promotion, catalyzing and metal deposition were performed as in Example 1. The results obtained were the same as for the filled resin composition of Example 1. Deposited copper on each filled resinous coating was found to be completely free of blisters and securely adhered to the adhesion promoted surface of the resinous cured coating layer.

EXAMPLE 3

Surface preparation of the panels, the composition of the filled resinous solutions and their electrophoretic application were as in Example 1. Alternate adhesion promotion systems were tested.

The following solutions were used in place of the first, acidic pre-treatment solution in the adhesion promotion step of Example 1:

```
1)  phosphoric acid                      50    ml/l
    an anionic fluorocarbon
      wetting agent                        2     g/l
    time                              1 - 15    minutes
    temperature                         25 °C
2)  sulfuric acid                         10 %   solution
    time                              1 - 15    minutes
    temperature                        25 - 45°C
3)  sulfuric acid                        600    ml
    phosphoric acid                     100    ml
    deionized water                     300    ml
    an anionic fluorocarbon
      wetting agent                      1 - 2 g
    time                           15 sec. - 15 minutes
    temperature                        25 - 55°C
```

With the exception of 2), the pre-treatment with these solutions was followed by a running rinse before inserting the panels into the oxidizing adhesion promotion solution. Furthermore, instead of the oxidizing solution of Example 1, the following composition was also used:

| chromium trioxide | 400 | g |
|---|---|---|
| phosphoric acid | 50 | ml |
| sulfuric acid | 200 | ml |
| deionized water · | 700 | ml |
| an anionic fluorocarbon | | |
| wetting agent | 2 | g |
| temperature | 25 – 65°C | |
| time | 2 – 20 | minutes |

The results were, again, completely satisfactory. Control experiments with panels provided with unfilled resinous coatings of Example 1 were, again, found to produce loose, blistery deposits.


EXAMPLE 4

A printed circuit board metal core substrate was produced by laminating on both sides of a 1 mm sheet of aluminum 0,2 mm of epoxy prepreg and a top layer of copper foil.

The metal core substrate panel was provided with holes and the aluminum surfaces exposed in the hole walls were etched back to increase the radius of the hole 25 to 35 μm compared to the original hole diameter by immersion in an aqueous 15% sodium hydroxide solution thus forming a recessed hole wall portion. Subsequently, the metal core surface forming said recessed hole wall portion was coated with the electrophoretically deposited, filled, resinous coatings of Example 1. The panels were rinsed and heated in an oven at 175° C for 30 minutes. All exposed aluminum surfaces of hole walls were covered with a pore-free, resinous coating.

The panels provided with the filled coating were adhesion promoted by the procedure of Example 3, using first the 3) acid solution at 45° C and then the oxidizing solution of Example 1. The panels were then plated with electrolessly deposited copper by the procedure of Example 1. The printed circuit patterns were outlined with a plating resist image, leaving the desired conductor pattern and the holes exposed. Copper up to a thickness of 25 μm was electro-plated onto the non-masked surface areas corresponding the desired conductor pattern and the hole walls. Then, a 7 μm thick tin-lead layer was plated on the copper surface. The plating resist mask was removed and the exposed copper layer between the conductors etched away with the before mentioned tin-lead layer acting as an etch-resist.

The completed printed circuit board was tested by floating the circuit board on molten solder at 288° C . There was no blistering or delamination of either the surface conductors or the plating on the hole walls. The resistance between the conductor pattern and the aluminum core was greater than $10^{10}$ ohms.

A group of plated through holes was cut from the printed circuit board and examined by microsectioning techniques. The copper plating on hole walls was complete and blister-free and uniformly adhered to the electrophoretically de posited, cured and adhesion promoted filled resinous coating.

The procedure was repeated using the unfilled prior art resinous coating of Example 1. Blisters on the hole walls were observed in the electrolessly deposited copper coating. The completed printed circuit board was tested by floating the circuit board on molten solder at 288° C for 10 seconds and was found to fail due to separation of the copper deposit from the hole walls.


EXAMPLE 5

An electrophoretic coating solution was prepared from two separate solutions:

| First solution: | deionized water | 7500 | ml |
| | phosphoric acid | 15,25 | ml |
| | lactic acid | 41,50 | ml |
| | resin 5276A ® | 1188 | g |
| | resin 5268 ® | 92,70 | g |
| Second solution: | deionized water | 100 | ml |
| | lactic acid | 2,8 | ml |
| | resin 5268 ® | 24,20 | g |
| | surfonyl defoamer | 0,80 | g |
| | No. 10 clay | 53,0 | g |
| | ethylene glycol monohexyl ether · | 25,0 | ml |

The filled electrophoretic coating solution was formulated by adding these two solutions to one liter of deionized water.

Epoxy prepregs were laminated to both sides of an aluminum sheet and provided with an adhesive layer comprising butadiene-acrylonitrile rubber and phenolic resin; the adhesive layer was cured and adhesion promoted by immersing the panel for 15 minutes in an aqueous solution at 40° C containing:

| chromium trioxide | 40 g/l |
| sulfuric acid | 300 ml/l |
| sodium fluoride | 30 ml/l |

After neutralization in sodium metabisulfite solutions, the adhesive layers were catalyzed for electroless copper deposition and electrolessly plated with a thin copper layer.

Holes were drilled through the resulting panel. The hole walls in the aluminum core were etched back by immersion for 20 minutes in a 20% sodium hydroxide solution at 35° C. The panel was rinsed for 8 minutes, immersed in a 15% hydrochloric acid solution for 1 minute, rinsed again for 1 minute and placed in the filled electrophoretic resinous coating solution. The hole walls formed by the aluminum core were cathaphoretically plated with the resinous coating at 24° C with a stepwise increase in plating voltage as follows:

| 0 – 30 seconds | 0 – 100 V |
| 30 sec. – 2,5 min. | 100 V |
| 2,5 min. – 4,5 min. | 125 V |
| 4,5 min. – 12,5 min. | 150 V |

After electrophoretically depositing the coating, the panel was rinsed and blown dry with a jet of air and the coating layer cured at 175° C for 1 hour.

The surface of the resinous coating was adhesion promoted by first immersing the panel for 5 minutes in the mixed sulfuric and phosphoric acid solution of Example 3, and then for 5 minutes in the oxidizing solution of Example 3. The cured resinous coating on the hole walls was 0,04 to 0,045 mm thick.

A printed circuit was produced on the panel by the semi-additive process. The adhesion of the copper to the hole walls was completely satisfactory.

EXAMPLE 6

Electrophoretic coating solutions were prepared from two separate solutions as in Example 5, with the second solution selected from the following compositions:

| | | | |
|---|---|---|---|
| A. | Deionized water | 100,0 | ml |
| | lactic acid | 2,8 | ml |
| | resin 5268 ® | 24,2 | g |
| | surfonyl defoamer | 0,8 | g |
| | No. 20 clay (hydrous aluminum silicate clay; particle size of 0,75 microns) | 53,0 | g |
| | ethylene glycol monohexyl ether | 25,0 | ml |
| B. | Deionized water | 100,0 | ml |
| | lactic acid | 2,8 | ml |
| | resin 5268 ® | 24,2 | g |
| | surfonyl defoamer | 0,8 | g |
| | No. 40 clay (hydrous aluminum silicate clay; particle size of 4,5 microns) | 53,0 | g |
| | ethylene glycol monohexyl ether | 25,0 | ml |
| C. | Deionized water | 100,0 | ml |
| | lactic acid | 2,8 | ml |
| | resin 5268 ® | 24,2 | g |
| | surfonyl defoamer | 0,8 | g |
| | hydrated amorphous silicate | 53,0 | g |
| | ethylene glycol monohexyl ether | 25,0 | ml |
| D. | Deionized water | 100,0 | ml |
| | lactic acid | 2,8 | ml |
| | resin 5268 ® | 24,2 | g |
| | surfonyl defoamer | 0,8 | g |
| | zirconium silicate | 53,0 | g |
| | ethylene glycol monohexyl ether | 25,0 | ml |
| E. | Deionized water | 100,0 | ml |
| | lactic acid | 2,8 | ml |
| | resin 5268 ® | 24,2 | g |
| | surfonyl defoamer | 0,8 | g |
| | fine particle talc | 53,0 | g |
| | ethylene glycol monohexyl ether | 25,0 | ml |
| F. | Deionized water | 100,0 | ml |
| | lactic acid | 2,8 | ml |
| | resin 5268 ® | 24,2 | g |
| | surfonyl defoamer | 0,8 | g |

13

| carbon black | 16,0 g |
| No. 10 clay (hydrous aluminum | |
| silicate clay) | 37,0 g |
| ethylene glycol monohexyl ether | 25,0 ml |

Each of these solutions A to F was then mixed with the first solution (Example 5) and deionized water to form the electrophoretic coating.

Test boards were prepared, coatings applied and adhesion promoted, as per Example 5. They were then electrolessly plated as per Example 1, resulting in smooth, faultless, blister-free, securely adhering deposits.

## Claims

1. A process for producing a printed circuit network on a metal core substrate comprising the successive steps of:-

    providing the surfaces of a metal core with one or more insulating surface layers to form the metal core substrate;

    providing said substrate with one or more holes for through connections;

    etching the hole walls defined by the metal core and by the insulating layer(s) to enlarge the hole diameter by a predetermined amount only in the portion of the hole(s) extending through said metal core;

    electrophoretically depositing on the etched portions of said hole walls a resinous coating from a resin solution, which solution comprises a solid filler being selected from metal silicates, such as aluminium or zirconium silicate, said filler being present in a concentration from 3 to 10% by weight of the cured resinous coating, and said filler further having an average particle size not exceeding $1\mu m$ in diameter, and being non-reactive with and uniformly dispersed in the resin solution, whereby the said concentration of the filler is selected such that the deposited resinous coating has a volume resistivity above $10^4$ Megohm-cm;

    curing the resinous coating, whereby the thickness of the resulting coating exceeds 0,025 mm;

    adhesion promoting the surface of the cured resinous coating containing said filler, thus creating a hydrophilic, micro-etched surface;

    depositing a metal layer on the resinous coating of the hole wall(s) and on the insulating surface layers, or selected parts thereof; and

    forming said printed circuit network.

2. The process of claim 1, characterized in that the adhesion promotion is accomplished by oxidation of the cured coating.

3. The process of claim 2, characterized in that the oxidation is accomplished by an aqueous oxidizing solution preferably comprising a hexavalent chromium compound.

4. The process of claim 2, characterized in that the adhesion promotion is accomplished by pretreatment with an acid solution followed by an oxidizing solution, said second oxidizing solution comprising hexavalent chromium.

5. The process of claim 1, characterized in that the resin solution mixture comprises a thermosetting resin selected from the group consisting of epoxy, acrylic, alkyd, epoxy-acrylate, polyimide, polyester, polamideimide resins and combinations thereof.

6. The process of claim 1, characterized in that the resin solution mixture comprises a thermoplastic resin selected from the group consisting of acrylates, polysulfones, polyetherketones and combinations thereof.

7. A printed circuit board comprising a metal core, insulating layers superimposed on the surfaces of said metal core and at least one hole through the insulating layers and metal core, the hole diameter defined by the metal core being greater than the hole diameter defined by the insulating layers; the metal walls of said hole(s) being coated with a cured resinous coating having a thickness exceeding 0.025 mm, said coating comprises a solid filler being selected from metal silicates, such as aluminium or zirconium silicate, said filler being present in a concentration from 3 to 10% by weight of the cured resinous coating, and said filler further having an average particle size not exceeding 1 $\mu$m in diameter, and being non-reactive with and uniformly dispersed in the resin solution, whereby the said concentration of the filler is selected such that the deposited resinous coating has a volume resistivity of $10^4$ Megohm-cm; said printed circuit board being produced in accordance with the process of claim 1.

## Revendications

1. Procédé pour la production d'un réseau de circuit imprimé sur un substrat à âme métallique comprend les étapes successives suivantes :

   munir les surfaces d'une âme métallique d'une ou plusieurs couches superficielles isolantes pour former le substrat à âme métallique ;

   munir ledit substrat d'un ou plusieurs trous pour connexions traversantes ;

   attaquer les parois des trous définies par l'âme métallique et par la ou les couches isolantes de manière à agrandir le diamètre du ou des trous dans une mesure prédéterminée uniquement dans la partie du ou des trous qui s'étend à travers ladite âme métallique ;

   déposer un revêtement résineux par électrophorèse à partir d'une solution de résine sur les parties attaquées desdites parois du ou des trous, laquelle solution comprend une charge solide choisie parmi des silicates de métaux, tels que le silicate d'aluminium ou de zirconium, ladite charge étant présente en une concentration de 3 à 10 % en poids du revêtement résineux cuit, et ladite charge ayant en outre une dimension particulaire moyenne ne dépassant pas 1 $\mu$m de diamètre et étant non-réactive avec la solution de résine et uniformément dispersée dans celle-ci, ladite concentration de la charge étant choisie de telle manière que le revêtement résineux déposé ait une résistivité volumique supérieure à $10^4$ mégohms-cm ;

   cuire le revêtement résineux, en sorte que l'épaisseur du revêtement résultant dépasse 0,025 mm ;

   activer l'adhérence de la surface du revêtement résineux cuit contenant ladite charge, en créant ainsi une surface hydrophile attaquée microscopiquement ;

   déposer une couche métallique sur le revêtement résineux de la paroi du ou des trous et sur les couches superficielles isolantes, ou des parties choisies de ceux-ci ; et

   former ledit réseau de circuit imprimé.

2. procédé selon la revendication 1, caractérisé en ce que l'activation d'adhérence est effectuée par oxydation du revêtement cuit.

3. Procédé selon la revendication 2, caractérisé en ce que l'oxydation est effectuée au moyen d'une solution aqueuse oxydante comprenant de préférence un composé de chrome hexavalent.

4. Procédé selon la revendication 2, caractérisé en ce que l'activation d'adhérence est effectuée par un prétraitement avec une solution acide, suivi par une solution oxydante, cette seconde solution, oxydante, comprenant du chrome hexavalent.

5. Procédé selon la revendication 1, caractérisé en ce que le mélange de la solution de résine comprend une résine thermodurcissable choisie dans le groupe formé par les résines époxy, les résines acryliques, les résines alkydes, les résines époxy-acryliques, les polyimides, les polyesters, les polyamide-imides et leurs associations.

6. Procédé selon la revendication 1, caractérisé en ce que le mélange de la solution de résine comprend une résine thermoplastique choisie dans le groupe formé par les résines acryliques, les polysulfones, les polyéther-cétones et leurs associations.

7. Plaquette de circuit imprimé comprenant une âme métallique, des couches isolantes superposées aux surfaces de ladite âme métallique et au moins un trou traversant les couches isolantes et l'âme métallique, le diamètre de trou qui est défini par l'âme métallique étant supérieur au diamètre de trou qui est défini par les couches isolantes ; les parois métalliques du ou desdits trous étant recouvertes par un revêtement résineux cuit ayant une épaisseur dépassant 0,025 mm, ledit revêtement comprenant une charge solide choisie parmi des silicates de métaux, tels que le silicate d'aluminium ou de zirconium, ladite charge étant présente en une concentration de 3 à 10 % en poids du revêtement résineux cuit, et ladite charge ayant en outre une dimension particulaire moyenne ne dépassant pas 1 µm de diamètre et étant non-réactive avec la solution de résine et dispersée uniformément dans celle-ci, la concentration de la charge étant choisie de telle manière que le revêtement résineux déposé ait une résistivité volumique de $10^4$ mégohms-cm ; ladite plaquette de circuit imprimé étant produite selon le procédé de la revendication 1.

## Ansprüche

1. Ein Verfahren zum Herstellen eines gedruckten Leiterzugnetzwerkes auf einer Metallkern-Trägerplatte bestehend aus den aufeinanderfolgenden Schritten:-

   Aufbringen einer oder mehrerer Isolierschichten auf den Oberflächen eines Metallkerns zum Herstellen einer Metallkern-Trägerplatte;

   Versehen der Trägerplatte mit einer oder mehreren Lochung(en) für elektrische Verbindungen;

   Ätzen der durch den Metallkern und die Isolierschicht(en) gebildeten Lochinnenwände in einem vorbestimmten Ausmaß zum Vergrößern des Lochdurchmessers ausschließlich in dem durch den Metallkern definierten Bereich der Lochung(en);

   elektrophoretisches Abscheiden einer Harzschicht auf den abgeätzten Bereichen der genannten Lochwandungen aus einer Harzlösung, die einen festen Füllstoff enthält, ausgewählt aus Metallsilikaten wie Aluminium- oder Zirkonsilikat, wobei die Konzentration des Füllstoffs zwischen 3 und 10 Gew.% der ausgehärteten Harzschicht entspricht, und die durchschnittliche Teilchengröße 1 µm Durchmesser nicht übersteigt, und er in der Harzlösung fein verteilt ist und mit dieser nicht reagiert, wobei die genannte Füllstoff-Konzentration so ausgewählt ist, daß die abgeschiedene Harzschicht einen Volumenswiderstand von mehr als $10^4$ Megohm-cm aufweist;

   Aushärten der Harzschicht, wobei die Dicke der ausgehärteten Schicht mehr als 0,025 mm beträgt;

   Behandeln der Oberfläche der ausgehärteten, den genannten Füllstoff enthaltenden Harzschicht zur Haftverbesserung, wobei eine hydrophile, mikroporöse Oberfläche entsteht;

   Abscheiden einer Metallschicht auf der die Lochwandungen bedeckenden Harzschicht sowie auf den Isolierstoff-Oberflächen, oder ausgewählten Bereichen davon; und

   Herstellen des genannten gedruckten Leiterzugnetzwerkes.

2. Das Verfahren nach Anspruch 1, dadurch gekennzeichnet, daß die Haftverbesserung durch oxidative Behandlung der ausgehärteten Harzschicht erfolgt.

3. Das Verfahren nach Anspruch 2, dadurch gekennzeichnet, daß für die Oxidationsbehandlung eine wässrige oxidierende Lösung verwendet wird, die vorzugsweise eine sechswertige Chromverbindung enthält.

4. Das Verfahren nach Anspruch 2, dadurch gekennzeichnet, daß die Haftverbesserung aus einer Vorbehandlung mit einer sauren und einer nachfolgenden Behandlung mit einer eine sechswertige Chromverbindung enthaltenden oxidierenden Lösung besteht.

5. Das Verfahren nach Anspruch 1, dadurch gekennzeichnet, daß die Harzlösung ein thermoplastisches Harz enthält, ausgewählt aus der Gruppe bestehend aus Epoxid-, Akryl-, Alkyd-, Epoxy-Akrylat-, Polyimid-, Polyester-, Polyamidimid-Harzen sowie Mischungen derselben.

6. Das Verfahren nach Anspruch 1, dadurch gekennzeichnet, daß die Harzlösung ein thermoplastisches Harz enthält, ausgewählt aus der Gruppe bestehend aus Akrylaten, Polysulfonen, Polyetheretherketonen und Gemischen derselben.

7. Eine gedruckte Schaltung mit einem Metallkern, dessen Oberflächen mit einer Isolierstoffschicht versehen sind, und mit mindestens einer, durch die Isolierstoffschichten und den Metallkern reichenden Lochung, deren im Bereich des Metallkerns liegender Durchmesser größer ist als jener im Bereich der

Isolierstoffschichten; und dessen (deren) metallische Innenwand (Innenwände) mit einer ausgehärteten Harzschicht von mehr als 0,025 mm Dicke versehen sind, wobei die Harzschicht einen festen Füllstoff enthält, ausgewählt aus Metallsilikaten wie Aluminium- oder Zirkonsilikat und in einer Konzentration von zwischen 3 bis 10 Gew.-% der ausgehärteten Harzschicht, und dessen durchschnittliche Teilchengröße 1 μm Durchmesser nicht übersteigt und der in der Harzlösung fein verteilt ist und mit dieser nicht reagiert, wobei die genannte Füllstoff-Konzentration so ausgewählt ist, daß die abgeschiedene Harzschicht einen Volumenswiderstand von mehr als $10^4$ Megohm-cm aufweist; und die Herstellung einer gedruckten Schaltung nach dem Verfahren entsprechend Anspruch 1.

17

## FIG. 1A

## FIG. 1B

## FIG. 1C

## FIG. 1D

## FIG. 1E